# EUROPÄISCHE PATENTSCHRIFT

(11) **EP 1 125 322 B1**
(45) Veröffentlichungstag und Bekanntmachung des Hinweises auf die Patenterteilung: **11.12.2013**
(21) Anmeldenummer: 99957875.0
(22) Anmeldetag: 11.10.1999
(51) Int. Cl.: H01L 21/332, H01L 29/74, H01L 29/32, H01L 21/263

(54) **VERFAHREN ZUR SELBSTJUSTIERENDEN ABSTIMMUNG VON THYRISTOREN MIT FOLGEZÜNDUNG**
METHOD FOR SELF-ADJUSTED TUNING OF THYRISTORS WITH SEQUENTIAL TRIGGERING
PROCEDE D'ACCORD AUTO-AJUSTÉ DE THYRISTORS A DECLENCHEMENT SEQUENTIEL

(30) Priorität: 27.10.1998 DE 19849547
(43) Veröffentlichungstag der Anmeldung: 22.08.2001
(73) Patentinhaber: Infineon Technologies Bipolar GmbH & Co. KG, 59581 Warstein (DE)
(72) Erfinder: SCHULZE, Hans-Joachim, D-85521 Ottobrunn (DE); RUFF, Martin, D-91487 Vestenbergsgreuth (DE)
(74) Vertreter: Bauer Vorberg Kayser Patentanwälte
(86) Internationale Anmeldenummer: PCT/DE1999/003260
(87) Internationale Veröffentlichungsnummer: WO 2000/025357

(56) Entgegenhaltungen:
- EP-A- 0 423 721
- EP-A- 0 833 388

## Beschreibung

Die Erfindung betrifft Verfahren zur selbstjustierenden Abstimmung von Thyristoren mit Folgezündung und insbesondere von Thyristoren mit Amplifying-Gate-Strukturen oder Pilotthyristoren.

Trotz der enormen Leistungen, die Thyristoren verarbeiten können, sind die Bauelemente empfindlich, insbesondere wenn sie gewollt oder unkontrolliert bei hoher Spannung eingeschaltet werden. Die dann eintretende "Über-Kopf-Zündung" kann zur Zerstörung des Thyristors führen. Besonders gefährdet sind lichtzündbare Thyristoren, da hier die zugeführte Zündleistung sehr klein ist und u.U. nicht ausreicht, um den Thyristor korrekt einzuschalten. Verbesserte lichtzündbare Hochleistungsthyristoren für Spannungen von bis zu 8 kV werden von H.-J. Schulze, M. Ruff, B. Baur, H. Kabza, F. Pfirsch, U. Kellner in "Light-Triggered 8 kV Thyristors with a New Type of Integrated Break-over Diode" in dem Tagungsband des "International Symposium for Semiconductor Power Devices", Maui (1996), beschrieben.

Das Problem der möglichen Zerstörung vor allem bei höheren Spannungen wie z.B. bei der "Über-Kopf-Zündung" wird mit sogenannten "Amplifying Gate"-Strukturen gelöst, die für ein verbessertes Zündverhalten des Thyristors sorgen. Diese Strukturen stellen im wesentlichen einen Pilotthyristor im Gate-Kreis des Hochleistungsthyristors dar. Der Zündthyristor zündet früher als der Hochleistungsthyristor. Der Pilotstrom ist sehr viel größer als der durch Licht bzw. von außen angelegte Strom zum Zünden des Hochleistungsthyristors, so daß durch den Pilotstrom der Hauptthyristor gezündet wird. Die amplifying-gate-Strukturen tragen somit zu einer kontrollierten Zündung des Hochleistungsthyristors bei und verbessern die Belastbarkeit des Bauelements gegenüber Stromspitzen mit hohem di/dt. Das Zünden in zwei Stufen wird als Folgezündung bezeichnet.

Die EP 0 432 721 A2 offenbart ein Verfahren zum Herstellen von Hochleistungsthyristoren mit Folgezündung, das folgende Schritte umfaßt: Erzeugen einer Thyristorstruktur aus einem Halbleiter mit mehreren Bereichen unterschiedlicher Leitfähigkeit, die einen Hauptthyristor und wenigstens einen Pilotthyristor umfaßt; Erzeugen von Defekten im Kristallgitter des Halbleiters in wenigstens einem Bereich des wenigstens einen Pilotthyristors *;* partielles Ausheilen des Kristallgitters durch Aufheizen der Thyristorstruktur mit einem Betriebsstrom.

Damit bei einem kleinen durch das Gate fließenden Zündstrom der durch den Thyristor geschaltete strom größer gemacht werden kann, werden mehrere Pilotthyristoren hintereinander geschaltet. Der erste Pilotthyristor zündet bei einer solchen Kaskadenschaltung dann den zweiten Pilotthyristor, der zweite Pilotthyristor schaltet den dritten Pilotthyristor usw., bis der letzte Pilotthyristor den Hauptthyristor zündet. Sobald ein Pilotthyristor einschaltet, muß also der nächste Pilotthyristor möglichst schnell folgen, um Stromdichteüberhöhungen und damit verbundene Aufheizeffekte, die zur Zerstörung des Bauelements führen können, zu vermeiden. Andererseits muß der Hochleistungsthyristor unempfindlich gegenüber steilen Spannungsstößen sein, d.h. ein vorzeitiges Zünden einzelner Pilotthyristoren muß vermieden werden, die Pilotthyristoren dürfen nicht zu zündempfindlich sein. Das bedeutet, daß die Pilotthyristoren in ihrer Empfindlichkeit so aufeinander abgestimmt werden müssen, daß die einzelnen Thyristoren möglichst kontinuierlich hintereinander einschalten.

Um die Pilotthyristoren möglichst gut einstellen zu können, wurde bisher die Zündempfindlichkeit der Pilotthyristoren durch Simulationsrechnungen abgeschätzt. Aufgrund dieser Simulationsrechnungen werden die entsprechenden lateralen und vertikalen Dimensionen des n⁺-Emitters des Pilotthyristors festgelegt. Die Simulationsrechnungen sind aber aufwendig, und es müssen daher Näherungen gemacht werden, so daß sich zwischen Simulation und realem Bauelement zwangsläufig Abweichungen ergeben können.

Da sich bei dem bisherigen Vorgehen die Dimensionierung von Pilotthyristoren also nur bis zu einem gewissen Grad optimieren läßt, ist es Aufgabe der vorliegenden Erfindung,

ein Verfahren zur Herstellung von Hochleistungsthyristoren mit Folgezündung anzugeben, mit dem eine optimale Zündausbreitung auch bei hohen di/dt-Werten möglich ist.

Diese Aufgabe wird durch ein Verfahren mit den Merkmalen nach Anspruch 1 gelöst. Bevorzugte Ausführungsformen sind Gegenstand der Unteransprüche.

Es wird ein Verfahren vorgeschlagen, bei dem sich die Empfindlichkeit der Pilotthyristoren von selbst so justiert, daß eine optimale Abstimmung der Empfindlichkeiten der einzelnen Pilotthyristoren und somit eine schnelle Zündausbreitung erreicht wird. Die Justierung der Pilotthyristoren erfolgt unter Strombelastung. Das erfindungsgemäße Verfahren zum Herstellen von Hochleistungsthyristoren mit Folgezündung, das das Erzeugen einer Thyristorstruktur aus einem Halbleiter mit mehreren Bereichen unterschiedlicher Leitfähigkeit umfaßt, wobei die Thyristorstruktur einen Hauptthyristor und wenigstens einen Pilotthyristor umfaßt, ist gekennzeichnet durch das Erzeugen von Defekten im Kristallgitter des Halbleiters in wenigstens einem Bereich des wenigstens einen Pilotthyristors und partielles Ausheilen des Kristallgitters durch Aufheizen der

Thyristorstruktur mit einem Betriebsstrom bei einer Temperatur von 300 °C solange, bis die Erwärmung in allen Pilotthyristoren annähernd gleich ist und sich damit von selbst ein Optimum der Zündempfindlichkeiten der einzelnen Pilotthyristoren eingestellt hat. Dadurch wird erreicht, daß Fehlanpassungen der geometrischen Abmessungen der Pilotthyristoren durch den sich einstellenden Widerstand des Pilotthyristors ausgeglichen werden.

Vorzugsweise erfolgt das Erzeugen von Kristallgitterdefekten in wenigstens einem Bereich des wenigstens einen Pilotthyristors durch Ionenimplantation, wobei die Ionen eine oder mehrere vorgegebene Energien und eine oder mehrere vorgegebene Dosen haben. Durch die Energie der Ionen wird die Tiefe der Kristallgitterdefekte unter der Oberfläche der Thyristorstruktur festgelegt, durch die Dosis wird das Ausmaß der Kristallgitterdefekte bestimmt, wobei mit unterschiedlichen Implantationsenerglen und -dosen heterogene Strukturen erzeugt werden können.

Als Ionen-werden bei der Ionenimplantation vorzugsweise Protonen, Heliumionen, Sauerstoff- oder Kohlenstoffionen verwendet.

Das Ausheilen mit einem Betriebsstrom erfolgt bei Silicium als Halbleiter bei einer Temperatur von 300°C. Insbesondere kann das Ausheilen mit einem Betriebsstrom durch eine Anzahl aufeinanderfolgender Stromstöße erfolgen, wobei die zeitliche Ableitung des einzelnen Stromstoßes mit der Anzahl des Stromstoßes zunimmt. D.h. der Anstieg des Stromstoßes ist bei dem ersten Stromstoß noch klein und nimmt bei den folgenden Stromstößen zu, bis ein vorgegebenes Maximum erreicht ist.

Ein Vorteil des erfindungsgemäßen Verfahrens besteht darin, daß die Selbstjustierung der Thyristorstruktur derart abläuft, daß die Selbstjustierung der Pilotthyristoren sehr einfach erfolgt und nur wenig Zeit und gerätetechnischen Aufwand erfordert.

Weitere Merkmale und Vorteile der Erfindung ergeben sich aus der folgenden Beschreibung einer bevorzugten Ausführungsform der Erfindung, wobei Bezug genommen wird auf die beigefügte Zeichnung.
Fig. 1 zeigt zur Erläuterung des Stromflusses bei Folgezündung zwei Strompfade bei einem herkömmlichen Thyristor mit Folgezündung und Pilotthyristor.
Fig. 2 zeigt einen Ausschnitt einer Ausführungsform eines Thyristors mit mehreren Pilotthyristoren unter Anwendung des erfindungsgemäßen Verfahrens.

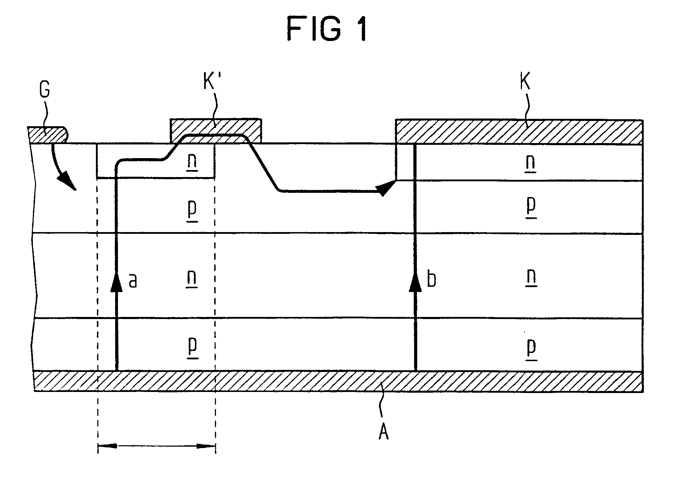

In Fig. 1 ist eine Form eines herkömmlichen Thyristors mit der Schichtfolge pnpn gezeigt. Der dargestellte Thyristor ist ein Thyristor mit Folgezündung, d.h. ein Thyristor mit integriertem Pilotthyristor. Die in Fig. 1 unterste Schicht ist eine p-Schicht, die mit einer Anode A des Thyristors verbunden ist. Darüber befindet sich eine n-Schicht und darüber eine weitere p-Schicht, die als Gate G dient und über die der Zündstrom für den Thyristor injiziert wird. Die oberste, n-dotierte Schicht ist mit einer Kathode K des Thyristors verbunden. Der gezeigte Thyristor weist zwei Kathoden K und K' auf. Die erste Kathode K im rechten Teil von Fig. 1 ist die Kathode des Hauptthyristors, die zweite Kathode K' im linken Teil von Fig. 1 ist die Kathode des Pilotthyristors. Der Pilotthyristor umfaßt also die Schichtfolge zwischen den beiden gestrichelten Linien in Fig. 1. Der Stromfluß in diesem Thyristor mit Folgezündung setzt sich aus zwei Anteilen zusammen. Ein erster Anteil a fließt durch den Pilotthyristor, wenn von einem Gate G der Thyristorstruktur ein Zündstrom fließt. Durch den Strom a wird ein Strom b in dem Hauptthyristor gezündet. Der Anteil b des Gesamtstroms ist sehr viel größer als der Anteil a in dem kleineren Pilotthyristor. Erst der Strom durch den Pilotthyristor kann den Strom im Hauptthyristor gleichmäßig zünden, während der ursprüngliche Strom durch das Gate G dazu evtl. nicht ausreicht.

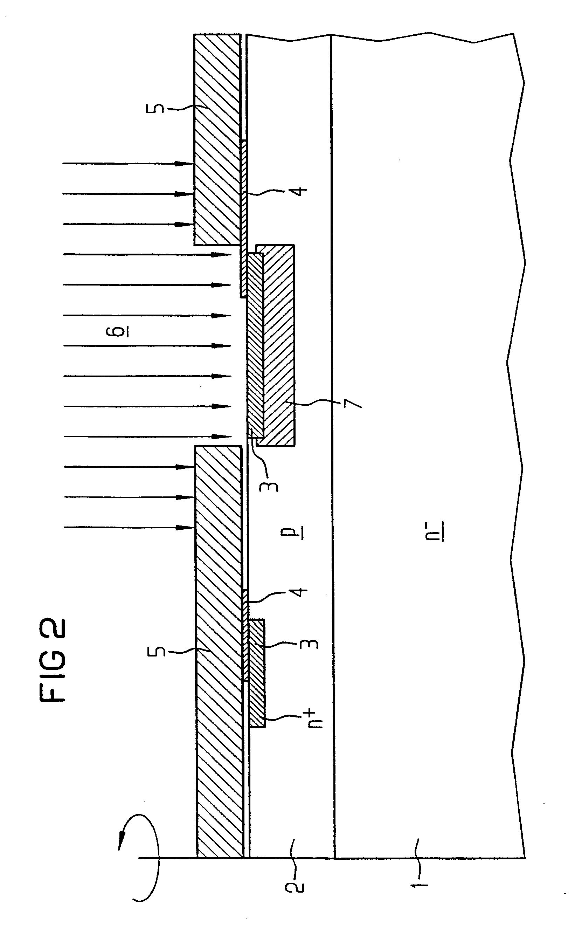

Damit bei einem vorgegebenen kleinen durch das Gate G fließenden Zündstrom a der durch den Hauptthyristor geschaltete Strom b möglichst groß gemacht werden kann, können mehrere Pilotthyristoren hintereinander geschaltet werden. Das erfindungsgemäße Verfahren, um diese hintereinander geschalteten Pilotthyristoren aufeinander abzustimmen, wird anhand Fig. 2 erläutert.

Fig. 2 zeigt als Ausschnitt einer Thyristorstruktur mit Folgezündung zwei Pilotthyristoren. Fig. 2 ist die Darstellung eines mittleren Abschnittes der Thyristorstruktur, die zentralsymmetrisch aufgebaut ist. Dies ist angedeutet mit der Linie links in der Fig. und einem gedrehten Pfeil. In dem Ausschnitt von Fig. 2 ist eine erste, n⁻-dotierte Thyristorschicht 1 und eine zweite, p-dotierte Thyristorschicht 2, die als p-Basis des Thyristors dient, dargestellt. An der Oberfläche der Thyristorstruktur befinden sich in der zweiten Thyristorschicht 2 zwei n⁺-dotierte Zonen 3, die jeweils einen n⁺-Emitter bilden. Die n⁺-Emitter 3 sind mit der Kathode 4 des jeweiligen Pilotthyristors verbunden. Die beiden n⁺-Emitter 3 haben eine unterschiedliche laterale Ausdehnung, d.h. eine unterschiedliche Ausdehnung in ihren Abmessungen parallel zur Oberfläche der Thyristorstruktur. Durch diese geometrischen Abmessungen wird grob der Zündstrom des jeweiligen Pilotthyristors eingestellt. Bei der Einstellung des Zündstroms von aufeinanderfolgenden Pilotthyristoren kommt es jedoch unvermeidlich zu Fehlanpassungen, d.h. der nachfolgende Pilotthyristor zündet zu früh oder später als gewünscht. Um diese Fehlanpassungen des Zündstroms zu korrigieren, ist eine nachträgliche Feineinstellung der Pilotthyristoren erforderlich.

Zur Feineinstellung der Pilotthyristoren wird erfindungsgemäß der Widerstand der p-Basis 2 unter dem n⁺-Emitter 3 im Bereich der Pilotthyristoren zunächst gezielt erhöht. So wird die Empfindlichkeit des einzelnen Pilotthyristoren gesteigert, da der für die Zündung des Pilotthyristors entscheidende, durch den Stromfluß verursachte Spannungsabfall unter dem n⁺-Emitter aufgrund des Anstiegs des Widerstands ebenfalls erhöht wird. Die lokale Erhöhung des Widerstands in der p-Basis erfolgt vorzugsweise durch eine gezielte, maskierte Bestrahlung des Halbleiters mit Ionen. Ionen, die zur Ionenimplantation für das gezielte Stören der Kristallgitterstruktur des Halbleiters geeignet sind, sind z.B. Heliumionen, Protonen, Sauerstoff- oder Kohlenstoffionen. Die Bestrahlung der Thyristorstruktur mit Ionen hat eine Verringerung der Beweglichkeit der freien Ladungsträger durch die Erzeugung von Defekten im Kristallgitter des Halbleiters und somit eine Erhöhung des Widerstands zur Folge.

In der Darstellung nach Fig. 2 ist zur Bestrahlung der Thyristorstruktur mit Ionen eine Maskierung 5 auf der Oberfläche der Thyristorstruktur vorgesehen, so daß nur gewünschte Bereiche der Struktur, d.h. die Bereiche der Pilotthyristoren bestrahlt werden. Die Maskierung 5 kann beispielsweise eine Metallblende sein. Sie weist dort Fenster auf, wo sich der zu bestrahlende Pilotthyristor befindet. Durch das Fenster in der Maskierung dringen die Ionen, die durch Pfeile 6 angedeutet sind, in die Thyristorstruktur ein und führen dort zu Störungen im Kristallgitter des Halbleiters. Bei der Bestrahlung treten die Defekte im Kristallgitter des Halbleiters vor allem in einer Zone auf, in der die Ionen schon einen Großteil ihrer Energie verloren haben. Diese Zone liegt in einer Tiefe unter der Oberfläche der Thyristorstruktur, die etwas geringer als die Eindringtiefe der Ionen ist. Das Ausmaß der erzeugten Kristallgitterdefekte in der Thyristorstruktur kann über die Wahl der Bestrahlungsenergie, die den Abstand der durch die Bestrahlung erzeugten defektreichen Zone von der Oberfläche des Siliziums festlegt, und die Bestrahlungsdosis, die die Beweglichkeit der Ladungsträger in der geschädigten Zone festlegt, gesteuert werden. Für bestimmte Dotierungsprofile der p-Basis und des n⁺-Emitters kann es auch sinnvoll sein, durch Wahl mehrerer Bestrahlungsenergien mehrere Zonen bzw. eine ausgedehntere Zone mit Kristallgitterdefekten des Halbleiters zu erzeugen. Der Bereich des Halbleiters mit Kristallgitterfehlern, die durch die Bestrahlung entstanden, ist in Fig. 2 mit 7 bezeichnet.

Die Kristallgitterdefekte des Halbleiters führen zu einer Erhöhung des Widerstands des Pilotthyristors in dem Bereich 7 gegenüber dem unbestrahlten Pilotthyristor und damit zu einer erhöhten Zündempfindlichkeit des bestrahlten Pilotthyristors. Der Bereich 7 des Pilotthyristors ist bezüglich seiner Zündausbreitung noch nicht optimiert, der Pilotthyristor ist zu zündempfindlich. Durch einen zweiten Verfahrensschritt muß die Zündempfindlichkeit wieder kontrolliert gesenkt werden, so daß sich die Zündempfindlichkeit aller Pilotthyristoren dabei aneinander anpaßt. Erfindungsgemäß wird der erhöhte Widerstand des bestrahlten Bereichs 7 ausgenutzt, um die Selbstjustierung der Zündempfindlichkeit der Pilotthyristoren zu erreichen. Dazu wird das Bauelement gezielt dissipativen Belastungen durch einen Stromstoß mit gegebenem Anstieg di/dt durch die gesamte Thyristorstruktur, d.h. durch jeden Pilotthyristor und durch den Hauptthyristor, ausgesetzt. Der Strom stellt sich durch die geometrischen Abmessungen in jedem Pilotthyristor von selbst ein. Beim Zünden der Thyristorstruktur kommt es aber in den jeweiligen Pilotthyristoren zu unterschiedlicher Erwärmung, nämlich zu einer höheren Erwärmung bei den zündempfindlichen Pilotthyristoren und einer weniger hohen Erwärmung bei den weniger zündempfindlichen Pilotthyristoren. Durch den Betriebsstrom resultieren in den Bereichen 7 mit erhöhtem Widerstand Temperaturerhöhungen. Die Temperaturerhöhungen führen ihrerseits zu einem Ausheilvorgang der durch die Ionenbestrahlung verursachten Strahlenschäden im Kristallgitter des Halbleiters. Das Ausheilen bedeutet eine teilweise Reorganisation des Gitters in den aufgeheizten Bereichen und führt zu einer Erhöhung der Beweglichkeit der Ladungsträger. Damit ist eine gewünschte Absenkung der Zündempfindlichkeit verbunden. Das Aufheizen mittels dissipativer Belastung durch einen Betriebsstrom führt also in den "zu empfindlichen" und daher stärker aufgeheizten Bereichen 7 zu einem partiellen Ausheilen des Kristallgitters und damit zu einer Absenkung der Zündempfindlichkeit. Die dissipative Belastung der Thyristorstruktur wird solange fortgesetzt, bis die Erwärmung in allen Pilotthyristoren annähernd gleich ist und sich damit von selbst ein Optimum der Zündempfindlichkeiten der einzelnen Pilotthyristoren eingestellt hat. Durch das Optimum der Zündempfindlichkeiten wird ein kontinuierliches Einschalten und eine möglichst geringe Temperaturerhöhung erreicht.

Die Temperaturen, bei denen Ausheilvorgänge der Strahlenschäden, die z.B. aus Komplexen aus Leerstellen und Sauerstoff sowie aus Doppelleerstellen bestehen, auftreten, liegen je nach Defekt oberhalb einer typischen Temperatur. Bei den in Silicium als Halbleiter erzeugten Defekten wird die Temperatur bei. 300°C gehalten.

In einer weiteren bevorzugten Ausführungsform des erfindungsgemäßen Verfahrens wird die di/dt-Belastung, d.h. die Belastung der Thyristorstruktur beim Einschalten des Betriebsstroms, mit der der Ausheilvorgang realisiert wird, vorsichtig gesteigert. Über einen vorgegebenen Zeitraum, der ausreichend lang ist, läßt man dann die Stromstöße durch die Thyristorstruktur einwirken. So stellen sich die Widerstände in den einzelnen Pilotthyristoren optimal auf einander abgestimmt von selbst ein.

Das beschriebene Verfahren zur nachträglichen Erhöhung des Widerstands in der p-Basis kann auch zur Nachjustierung der Empfindlichkeit eines Pilotthyristors verwendet werden; d.h. wenn man bei einem speziellen Pilotthyristor z.B. durch Zündausbreitungsmessungen feststellt, daß ein oder mehrere Pilotthyristoren nicht zündempfindlich genug sind, läßt sich die Empfindlichkeit dieses bzw. dieser Pilotthyristoren mittels einer durch Maskierung realisierten lokalen Bestrahlung in diesen Bereichen nachträglich so erhöhen, daß eine zufriedenstellende Zündausbreitung gewährleistet ist.

## Patentansprüche

1. Verfahren zum Herstellen von Hochleistungsthyristoren mit Folgezündung, das umfasst:
a) Erzeugung einer Thyristorstruktur aus Silizium, die einen Hauptthyristor und mehrere Pilotthyristoren umfasst, wobei die Thyristorstruktur eine erste Schicht einer ersten Leitfähigkeit (1), eine Basisschicht einer zweiten Leitfähigkeit, die zu der ersten Leitfähigkeit (2) entgegengesetzt ist, und Emitterkonen (3) der Pilotthyristoren an der Oberfläche der Basisschicht umfasst, wobei die Emitterbereiche die erste Leitfähigkeit haben;
b) Erzeugen von Defekten in dem Kristallgitter des Siliziums in wenigstens einem Bereich (7) unter dem Emitter wobei (3) eines jeweiligen Pilotthyristors in der Basisschicht (2) mittels Ionenimplantation von mindestens einem von Protonen, Heliumatomen, Sauerstoffionen und Kohlenstoffionen; und
c) partielles Ausheilen des Kristallgitters durch Aufheizen der Thyristorstruktur mit einem Betriebsstrom bei einer Temperatur von. 300°C solange, bis die Erwärmung in allen Pilotthyristoren annähernd gleich ist und sich damit von selbst ein Optimum der Zündempfindlichkeiten der einzelnen Pilotthyristoren eingestellt hat.

2. Verfahren nach Anspruch 1, wobei die Ionenimplantation mit einer oder mehreren vorgegebenen Energien und einer oder mehreren vorgegebenen Dosen durchgeführt wird.

3. Verfahren nach einem der vorangehenden Ansprüche, wobei das Ausheilen mit einem Betriebsstrom durch eine Anzahl von aufeinander folgenden Stromstößen erfolgt, wobei die zeitliche Ableitung des einzelnen Stromstoßes mit der Anzahl des Stromstoßes zunimmt.

## Claims

1. A method for producing high-power thyristors with sequential triggering, comprising:
a) generating a thyristor structure consisting of silicon comprising a primary thyristor and several pilot thyristors, the thyristor structure comprising a first layer with a first conductivity (1), a base layer with a second conductivity opposite to the first conductivity (2), and emitter zones (3) of the pilot thyristors at the surface of the base layer, the emitter zones having the first conductivity;
b) generating defects in the crystal lattice of the silicon in at least one region (7) underneath the emitter zone (3) of a respective pilot thyristor in the base layer (2) by means of ion implantation of at least one of protons, helium atoms, oxygen ions and carbon ions; and
c) partial annealing of the crystal lattice by heating up the thyristor structure with an operating current at a temperature of 300°, until the heating level in all pilot thyristors is approximately the same, so that thus, an optimum of triggering sensitivities of the individual pilot thyristors has set itself.

2. The method according to claim 1, wherein the ion implantation is carried out with one or more predetermined energies and one or more predetermined doses.

3. The method according to any one of the preceding claims, wherein annealing with an operating current takes place by means of a number of successive current pulses, the time derivative of the individual current pulse increasing with the number of the current pulse.

## Revendications

1. Procédé de fabrication de thyristors de puissance à déclenchement séquentiel, comprenant :
a) réaliser une structure de thyristor en silicium qui comprend un thyristor principal et une pluralité de thyristors pilotes, ladite structure de thyristor comprenant une première couche d'une première conductivité (1), une couche de base d'une deuxième conductivité qui est opposée à la première conductivité (2) ainsi que des zones émettrices (3) des thyristors pilotes à la surface de ladite couche de base, lesdites zones émettrices ayant la première conductivité,
b) produire des défauts dans le réseau cristallin du silicium dans au moins une zone (7) au-dessous de la zone émettrice (3) d'un thyristor pilote respectif dans la couche de base (2) par l'intermédiaire d'une implantation ionique de l'un au moins de protons, d'atomes de hélium, d'ions d'oxygène et d'ions de carbone, et
c) régénérer en partie le réseau cristallin par chauffage de la structure de thyristor avec un courant de service à une température de 300 °C jusqu'à ce que l'échauffement soit approximativement le même dans l'ensemble des thyristors pilotes et que, ainsi, un optimum des sensibilités de déclenchement des thyristors pilotes individuels se soit réglé automatiquement.

2. Procédé selon la revendication 1, dans lequel ladite implantation ionique est réalisée avec une ou plusieurs énergie(s) donnée(s) et avec une ou plusieurs dose(s) donnée(s).

3. Procédé selon l'une quelconque des revendications précédentes, dans lequel la régénération avec un courant de service est réalisée par un nombre de coups de courant successifs, la dérivation temporelle du coup de courant individuel augmentant avec le nombre du coup de courant.
